# EUROPEAN PATENT APPLICATION

(11) **EP 4 707 832 A1**
(43) Date of publication of application: **11.03.2026**
(21) Application number: 24199582.8
(22) Date of filing: 10.09.2024
(51) Int. Cl.: G01R 31/392, G01R 31/396

(54) **MONITORING BATTERY BLOCKS OF A BATTERY**

(71) Applicant: Novum engineerING GmbH, 01067 Dresden (DE)
(72) Inventor: BIRTH, Sören, 01307 Dresden (DE); SCHMEIDA, Toni, 01187 Dresden (DE)
(74) Representative: Ter Meer Steinmeister & Partner

(57) **Abstract**

A system and a method of monitoring the behavior of battery blocks (b1,...,bn) connected in series. For each of a plurality of points in time (t₀,t ₋₁,t ₋₂), and for each battery block, a deviation value (ΔQ_{b1}, ..., ΔQ_{bn}) is calculated, being a voltage deviation of the voltage measurement from an average (M) of the voltage measurements (U_{b1},...,U_{bn}) of the battery blocks, or a corresponding charge deviation. The deviation values (ΔQ_{b1}, ..., ΔQ_{bn}) of the battery block are aggregated. The aggregated deviation values (10) are evaluated with respect to a reference aggregated deviation value (12), to detect a potentially anomalous state of the battery block. The reference aggregated deviation value (12) is obtained based on corresponding aggregated deviation values (10) of a corresponding battery block of corresponding batteries (14).

## Description

The invention relates to monitoring the behavior of a plurality of battery blocks that are connected in series in a battery, for detecting an anomalous state of one of the plurality of battery blocks.

### Summary of the invention

Batteries, in particular electrochemical batteries such as lithium ion batteries, are increasingly used for battery storages. It is desirable to provide for an economical, safe and sustainable operation of a battery storage.

It is an object of the present invention to provide a novel method of monitoring the behavior of a plurality of battery blocks that are connected in series in a battery.

It is desirable that the method allows for monitoring the behavior of the battery blocks on the basis of only electrical parameters that are readily available in a battery management system of a battery storage.

It is desirable that the method allows for establishing the monitoring of the behavior of the battery blocks in an unobtrusive manner.

In particular, it is desirable that the method allows for monitoring the behavior of the battery blocks on the basis of only voltage measurements, taken at respective points in time.

It is furthermore desirable to be able to automatically detect an anomalous state of one of the plurality of battery blocks, in particular a potentially safety-relevant state and/or a state reflecting a manufacturing defect.

It is furthermore desirable that the method may detect an anomalous state of a battery block without having to rely on an ideal or perfectly normal battery as a reference.

The invention is indicated in the independent claims. Further embodiments are indicated in the dependent claims.

According to one aspect of the invention, there is provided a method of monitoring the behavior of a plurality of battery blocks that are connected in series in a battery, for detecting a potentially anomalous state of one of the plurality of battery blocks. The method comprises: for each point in time of a plurality of points in time, providing a voltage measurement of each of the plurality of battery blocks measured at the point in time. The method further comprises: for each point in time of the plurality of points in time, and for each battery block of the plurality of battery blocks, calculating a deviation value of the battery block. The deviation value is a voltage deviation of the voltage measurement of the battery block from an average of the voltage measurements of the plurality of battery blocks (at that point in time), or is a charge deviation of the battery block that corresponds to the voltage deviation. The method further comprises: for each battery block of the plurality of battery blocks and for a first time frame, aggregating the deviation values of the battery block that have been calculated for the points in time belonging to the first time frame, to determine an aggregated deviation value. That is, an aggregated deviation value is determined by aggregating the deviation values of the battery block of the points in time that belong to the first time frame. The method further comprises: for each battery block of the plurality of battery blocks, evaluating the aggregated deviation value to detect a potentially anomalous state of the battery block. Said evaluating comprises evaluating the aggregated deviation value with respect to at least one reference aggregated deviation value. The reference aggregated deviation value may be obtained based on corresponding aggregated deviation values of a corresponding battery block of corresponding batteries.

The battery may also be termed "the monitored battery". During usage of the battery, the battery blocks connected in series typically undergo the same succession of charging, energy storing, discharging, and so on. Moreover, the battery blocks typically are of a similar structure and similar age, having similar electrical parameters such as the capacity. When calculating the deviation value of a battery block, the average of the voltage measurements of the battery blocks is used as a reference that is "self-generated" on a local basis. The voltage measurements stem from the battery blocks that are subject to a same current, at a point in time, because the battery blocks are connected in series. The difference between a voltage measurement of an individual battery block and the average of the voltage measurements of the battery blocks may not show any significant characteristics, when taken alone. However, by aggregating the deviation values and evaluating them with respect to at least one reference aggregated deviation value that has been obtained based on respective corresponding battery blocks of corresponding batteries, effects of different charge states are balanced over the first time frame. Moreover, seasonal effects as well as effects due to the type of construction of the batteries are levelled, as these effects are expected to affect the monitored battery and the corresponding batteries in a similar way. Thus, based on the voltage measurements, and using the average of the voltage measurements of the battery blocks as a "self-generated" reference, and using a further "self-generated" external reference in form the of reference aggregated deviation values stemming from corresponding batteries, a potentially anomalous state of one of the battery blocks connected in series may be detected.

Corresponding batteries may be batteries that are structurally identical with the monitored battery, or batteries of a similar type as the monitored battery. The corresponding batteries include batteries other than the (monitored) battery of which the voltage measurements are provided.

Corresponding aggregated deviation values of a corresponding battery block of corresponding batteries are obtained in the same manner as the aggregated deviation value that is determined for the respective block of the plurality of battery blocks of the monitored battery. That is, the corresponding aggregated deviation values may be determined in a manner that corresponds to the steps of calculating a deviation values and aggregating the deviation values of the corresponding battery block of the monitored battery. Likewise, deviation values of battery blocks of corresponding batteries are obtained in the same manner as the deviation values of the respective block of the plurality of battery blocks of the monitored battery. Deviation values of battery blocks of corresponding batteries may also be called corresponding derivation values.

Thus, the at least one reference aggregated deviation value may be obtained based on corresponding measurements of a plurality of batteries of a similar kind ("corresponding batteries"), in particular batteries that structurally identical with the monitored battery. This is particularly advantageous in that, for example, the behavior of a specific battery block, say battery block #n of the battery blocks connected in series, may be evaluated with respect to the behavior of battery block #n of a plurality of structurally identical batteries in the field. Whereas a battery block #n might have a specific behavior, this specific behavior might be due to constructional differences between the battery blocks connected in series and might appear in a similar manner in the plurality of structurally identical batteries. However, when the behavior of battery block #n is different from the behavior of battery block #n of a plurality of structurally identical batteries, an anomalous state may be detected. Thus, detection of a potentially anomalous state of a respective one of the battery blocks is considerably improved.

The corresponding aggregated deviation values of a corresponding battery block of corresponding batteries may be obtained for a corresponding time frame that corresponds to the respective first time frame or, where applicable, second time frame. In particular, both time frames that correspond to each other may have a same duration and/or may overlap for the most part thereof.

The term "battery block" is understood as being a unit in a battery or battery storage, for which unit voltage measurements are available. The battery block may include one or more battery cells. In particular, the battery block may include multiple battery cells connected in parallel. The term "battery block" may include a single battery cell.

The battery may include a battery module or a battery string, in which the said plurality of battery blocks are connected in series. The battery may be a part of a battery storage. The battery storage may comprise a battery management system.

The term "voltage measurement" is understood to mean a value obtained by measuring the voltage. The providing of the voltage measurement may include measuring the voltage to obtain the voltage measurement. For example, the voltage measurement may be provided by the battery management system. The voltage measurement is measured at the respective point in time. For example, the voltage measurement may be taken at the point in time or may have occurred at the point in time.

The calculated deviation value is associated with the point in time of the corresponding voltage measurement. It may be said that the deviation value "occurred" at the point in time, or "occurred" at the voltage measurement that has been measured at the same point in time.

The calculated deviation value is a signed deviation value, that is, the sign of the voltage deviation from the average of the voltage measurements is preserved. If applicable, the sign of the charge deviation corresponds to the sign of the voltage deviation.

The charge deviation may be an estimated charge deviation. The charge deviation may be estimated based on the voltage deviation. For example, the charge deviation of the respective battery block may be estimated based on the voltage deviation of the battery block and based on a voltage-charge characteristic. The voltage-charge characteristic may be a voltage-charge characteristic of the battery block or the plurality of battery blocks. The charge deviation may be calculated according to voltage-charge characteristics of the battery block or the plurality of battery blocks, and based on the voltage measurement of the battery block. The voltage-charge characteristic may define a relation between voltage and charge at different voltages. The voltage-charge characteristic may be an ideal or estimated voltage-charge characteristic. The voltage-charge characteristic may be a voltage-charge curve, in particular a voltage-SoC-curve describing a relation of voltage and state of charge (SoC). For example, at a specific voltage (voltage measurement), the slope or the local behavior of the voltage-charge curve describes a relation between the voltage deviation and a corresponding charge deviation at said specific voltage.

The first time frame may have a predetermined length or duration. The length of the first time frame may be at least 14 days, preferably at least 20 days, more preferably at least 28 days. Thereby, typically, voltage measurements at many different states of charge of the battery may be included with the voltage measurements. The length of the first time frame may be less than 2 months, preferably less than 1 month. Thereby, development of an anomalous state of a battery block may be detected on a suitable time scale.

The number of the points in time that belong to the first time frame may be at least 100.000, preferably at least 400.000.

The plurality of points in time may succeed one another at a temporal distance of, for example, one second or more. The temporal distance may be at least one second, or at least 5 seconds. The temporal distance may be 1 hour or less, 10 minutes or less, 5 minutes or less, or, preferably 60 seconds or less.

In embodiments, said average of the voltage measurements of the plurality of battery blocks is the median of the voltage measurements of the plurality of battery blocks.

However, the average may also be the arithmetic mean or other central tendency of the voltage measurements of the battery blocks measured at said respective point in time.

The aggregated deviation value may also be termed a total deviation value.

In embodiments, said aggregating comprises calculating the sum of the absolute values of the deviation values of the respective battery block that have been calculated for the points in time belonging to the first time frame. In other words, the aggregated deviation value is the sum of the absolute values of the deviation values of the respective battery block that have been calculated for the points in time belonging to the first time frame. Alternatively, the aggregated deviation value may be calculated to be the sum of the squares of the absolute values of the deviation values of the respective battery block that have been calculated for the points in time belonging to the first time frame.

In embodiments, said evaluating of the aggregated deviation value with respect to at least one reference aggregated deviation value comprises scaling and/or adjusting the determined aggregated deviation value based on the at least one reference aggregated deviation value, or comprises comparing the determined aggregated deviation value to at least one of the at least one reference aggregated deviation value.

The method may comprise: when the scaled and/or adjusted determined aggregated deviation value is larger than a threshold value, a potentially anomalous state of the battery block is detected. That is, it is detected that the battery block has a potentially anomalous state.

The method may comprise: when the scaled and/or adjusted determined aggregated deviation value is larger than an upper threshold value or is smaller than a lower threshold value, a potentially anomalous state of the battery block is detected. That is, it is detected that the battery block has a potentially anomalous state.

Adjusting the determined aggregated deviation value may comprise subtracting a reference aggregated deviation value, for example, subtracting the median of the corresponding aggregated deviation values of the corresponding battery block of the corresponding batteries.

Scaling the determined aggregated deviation value (for example, scaling the adjusted determined aggregated deviation value) may comprise dividing the aggregated deviation value by a reference aggregated deviation value, or dividing the aggregated deviation value by a difference between an upper reference aggregated deviation value (or first upper threshold value) and a lower reference aggregated deviation value (or first lower threshold value).

The method may comprise: when the determined aggregated deviation value is larger than a reference aggregated deviation value, a potentially anomalous state of the battery block is detected. That is, it is detected that the battery block has a potentially anomalous state.

The at least one reference aggregated deviation value may be at least one first threshold value.

The at least one reference aggregated deviation value may be a (statistical) representation of aggregated deviation values of corresponding batteries.

In particular, the at least one reference aggregated deviation value may be a statistical representation of corresponding aggregated deviation values of a corresponding battery block of corresponding batteries.

For example, at least one of the reference aggregated deviation value (for example, an upper aggregated reference deviation value) may be an n-th q-quantile of the corresponding aggregated deviation values of a corresponding battery block of corresponding batteries, wherein n/q is at least 0.5.

For example, at least one of the at least one reference aggregated deviation value (for example, a lower aggregated reference deviation value) may be an (q-n)-th q-quantile of the corresponding aggregated deviation values of a corresponding battery block of corresponding batteries.

Preferably, n/q is at least 0.75, at least 0.8, or at least 0.9. For example, n/q may be less than 0.95. For example, n/q may be 0.9.

Thus, for a battery block, only those corresponding aggregated deviation values of the corresponding battery block of the corresponding batteries are taken into account for evaluating the aggregated deviation value, which are above (and/or below) a respective threshold value that cuts off the lowest (and/or, respectively, highest) aggregated deviation values of the corresponding aggregated deviation values. This improves the robustness of the evaluation.

The term q-quantile of the corresponding aggregated deviation values refers to a q-quantile of a distribution of the corresponding aggregated deviation values of a corresponding battery block of corresponding batteries. If q=100, the n-th q-quantile is the n-th percentile.

In embodiments, the steps of aggregating the deviation values and evaluating the aggregated deviation value (to detect a potentially anomalous state of the battery block) are repeated for at least one second time frame. Said evaluating may comprise: when a deviation of the respective determined aggregated deviation value from at least one of the respective at least one reference aggregated deviation value passes (exceeds, or falls below) a threshold value for a predetermined duration of monitoring time, detecting a potentially anomalous state of the battery block.

In embodiments, said evaluating the aggregated deviation value (to detect a potentially anomalous state of the battery block) further comprises: evaluating a ratio of the square of the aggregated deviation value of the battery block to the sum of the squares of the aggregated deviation values of the other battery blocks of the plurality of battery blocks (that are connected in series in the battery). Thus, calculating the ratio is similar to calculating a signal-to-noise ratio, the "signal" being the aggregated deviation value of the evaluated battery block and the "noise" corresponding to the aggregated deviation values of the other battery blocks of the plurality of battery blocks. In embodiments, said evaluating of the ratio of the square of the aggregated deviation value may be evaluating a ratio of the square of the scaled and/or adjusted aggregated deviation value.

Evaluating said ratio allows for a better detection of an anomalous state of a battery block in specific cases: For example, a battery block of the plurality of battery blocks might have an aggregated deviation value that appears suspicious when evaluated with respect to corresponding batteries in the field, that is, with respect to the at least one reference aggregated deviation value. However, this may be due to a variation between batteries caused by the battery construction process, and the monitored battery block may nevertheless be in a normal, regular state. By evaluating the ratio, the aggregated deviation value is compared with those of the other blocks of the same (monitored) battery. Thereby, such variations may be excluded from being detected as an anomalous state. Thus, the validity of the evaluating may be improved.

In embodiments, said evaluating of the ratio comprises comparing the ratio to a second threshold value.

The method may comprise: when the ratio is larger than the second threshold value, a potentially anomalous state of the battery block is detected. That is, it is detected that the battery block has a potentially anomalous state.

In embodiments, the steps of aggregating the deviation values and evaluating a ratio are repeated for at least one second time frame, wherein said evaluating comprises: when the respective ratio passes (exceeds and/or, respectively, falls below) a third threshold value for a predetermined duration of monitoring time, detecting a potentially anomalous state of the battery block.

In embodiments, wherein the steps of aggregating the deviation values and evaluating a ratio are repeated for at least one second time frame, wherein said evaluating comprises: detecting a positive deviation of the respective ratio with respect to a fourth threshold value; and determining whether the positive deviation increases over monitoring time.

An increase over monitoring time may be determined, for example, by repeating the steps of aggregating the deviation values and evaluating a ratio for at least one second time frame, for example, for a plurality of new second time frames, each second time frame progressing in time with respect to the preceding time frame; detecting the positive deviation for each of the time frames; and determining an increase of the deviation based on linear regression of the detected deviations, for example. An increase of the deviation may also be determined by other algorithms.

Herein, an increasing (or decreasing) over monitoring time may comprise an increasing (or decreasing) in time in a direction towards the (end of the) latest time frame, in particular, from the first time frame towards (the end of) at least one second time frame.

In the above described embodiments in which the steps of aggregating the deviation values and evaluating the aggregated deviation value and/or evaluating a ratio are repeated for at least one second time frame, one or more of the following features may apply:
The steps of aggregating the deviation values and evaluating the aggregated deviation value and/or evaluating a ratio may be repeated for a plurality of new second time frames, each second time frame progressing in time with respect to the preceding time frame.

The second time frame may be an updated time frame. For example, a new second time frame may be processed every day. Each second time frame may overlap with the previous, or first, time frame by a time overlap. Each first and second time frame may have a same length or duration.

The monitoring time may extend over a longer time than the length of the respective time frame.

The steps of aggregating the deviation values and evaluating the aggregated deviation value may be repeated for new/updated time frames, for example, on a daily basis, or after a number of days, which number is preferably at least 1 and/or preferably less than 8. Each new time frame may overlap with a previous time frame. For example, each new time frame may overlap with a previous time frame by at least one day, or said number of days.

In any of the above-described embodiments, the method may include one or more of the following features:
The method may be a computer-implemented method.

The method may include: gathering, from corresponding batteries, a respective at least one corresponding deviation value that is specific to a corresponding battery block of a corresponding battery. The method may include determining the at least one reference aggregated deviation value based on a corresponding deviation value specific to a corresponding battery block of corresponding batteries.

The voltage measurements of the plurality of battery blocks of the monitored battery may be received through a communication network. The voltage measurements of corresponding battery blocks of corresponding batteries may be received through a communication network. The reference aggregated deviation values and/or the corresponding aggregated deviation values of corresponding battery blocks of corresponding batteries may be received through a communication network. The communication network may be a telecommunications network, for example the internet or a mobile network.

In embodiments, the potentially anomalous state of the battery block is a potentially safety-relevant state and/or a state reflecting a manufacturing defect.

The method may comprise detecting a potentially safety-relevant state and detecting a state reflecting a manufacturing defect. In particular, a safety-relevant state may be detected independently from detecting a state reflecting a manufacturing defect. In particular, when a deviation from an expected behavior or from a deviation of the respective ratio is detected to increase over monitoring time, this may be detected as a potentially safety-relevant state.

In an aspect of the invention, there is provided a battery monitoring system, the system comprising means for carrying out the steps of the method as described herein. In at least one embodiment, the system comprises computational means for receiving and processing the voltage measurements. The system may comprise means for receiving and/or calculating the reference aggregated deviation values.

Preferred embodiments of the invention will now be described in conjunction with the drawings, in which:
Fig. 1 is a schematic illustration of a method of and system for monitoring the behavior of a plurality of battery blocks that are connected in series in a battery; and
Fig. 2 is a schematic illustration of steps of another method of monitoring the behavior of a plurality of battery blocks that are connected in series in a battery.

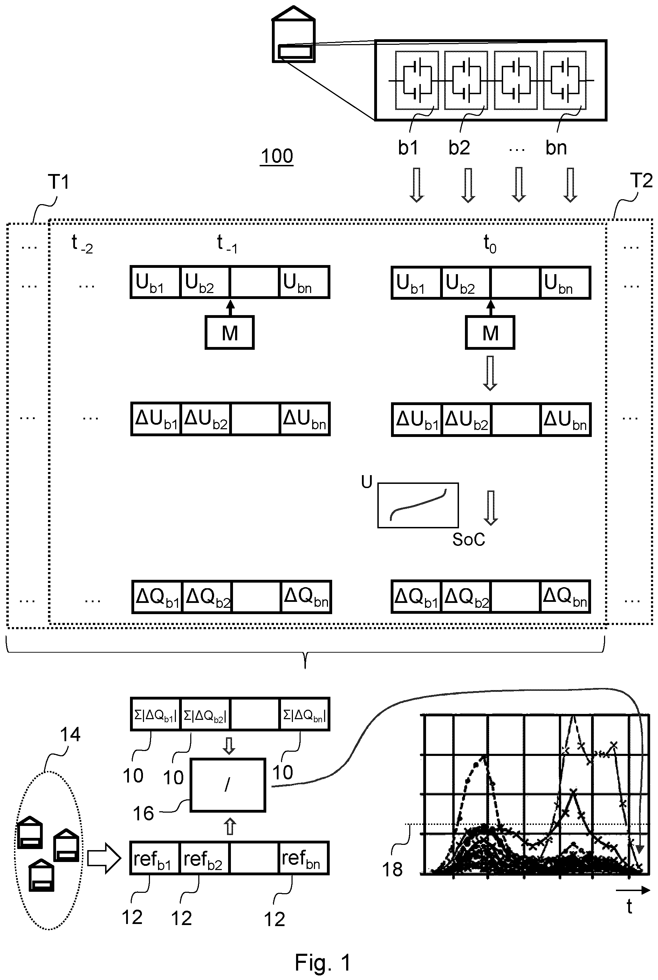

Fig. 1 schematically shows a method of and system 100 for monitoring the behavior of a plurality of battery blocks b1, ..., bn that are connected in series in a battery, for detecting a potentially anomalous state of one of the plurality of battery blocks b1, ..., bn. The battery may be a part of a battery storage.

For each point in time of a plurality of points in time t₀, t ₋₁, t ₋₂, ..., there is provided a voltage measurement U_{b1}, ..., U_{bn} of each of the plurality of battery blocks b1, ..., bn measured at the point in time. For example, the measurements may be taken every 1 to 60 seconds, or every 5 minutes over a first time frame T1 of, for example, 28 days.

For the first time frame T1, the following operations are performed:
For each point in time of the plurality of points in time t₀, t ₋₁, t ₋₂, ... that belong to the first time frame T1, and for each battery block of the plurality of battery blocks b1, ..., bn, an average M in form of the median of the voltage measurements U_{b1}, ..., U_{bn} of the plurality of battery blocks b1, ..., bn, is calculated. Furthermore, a voltage deviation value ΔU_{b1}, ..., ΔU_{bn} of the battery block is calculated. The voltage deviation value ΔU_{b1}, ..., ΔU_{bn} is a voltage deviation of the voltage measurement U_{b1}, ..., U_{bn} of the battery block from the average M of the voltage measurements U_{b1}, ..., U_{bn} of the plurality of battery blocks b1, ..., bn for the respective point in time.

Based on the voltage deviation values ΔU_{b1}, ..., ΔU_{bn}, respective deviation values in the form of charge deviation values ΔQ_{b1}, ..., ΔQ_{bn} are calculated according to a voltage-charge characteristic, for example, in the form of a voltage-SoC-curve.

For each battery block of the plurality of battery blocks b1, ..., bn and for the first time frame T1, the deviation values ΔQ_{b1}, ..., ΔQ_{bn} of the battery block that have been calculated for the points in time belonging to the first time frame T1 are aggregated to determine an aggregated deviation value 10. In particular, the aggregated deviation value 10 is calculated in the form of the sum of the absolute values of the deviation values ΔQ_{b1}, ..., ΔQ_{bn} of the respective battery block that have been calculated for the points in time belonging to the first time frame T1.

For each battery block of the plurality of battery blocks b1, ..., bn, the aggregated deviation value 10 is scaled (indicated as 16) based on a reference aggregated deviation value 12. The reference aggregated deviation value 12 is obtained based on corresponding aggregated deviation values of a corresponding battery block of corresponding batteries 14. The reference aggregated deviation value 12 is a statistical representation of corresponding aggregated deviation values 10 of a corresponding battery block of corresponding batteries 14. Specifically, the reference aggregated deviation value 12 is the 90th percentile of corresponding aggregated deviation values 10 of a corresponding battery block of corresponding batteries 14.

The (scaled) aggregated deviation value 10 is then evaluated to detect a potentially anomalous state of the battery block. The respective (scaled) aggregated deviation value 10 is compared to a threshold value 18.

Specifically, the steps of aggregating the deviation values and evaluating the aggregated deviation value 10 are repeated for a plurality of second time frames T2. For each second time frame T2, the end point of the time frame T2 corresponds to a respective monitoring time t, and the respective aggregated deviation value 10 is assigned to that time t.

In the lower right part of Fig. 1, there is shown a diagram of the resulting (scaled) aggregated deviation value 10 of each of the battery blocks b1, ..., bn over the monitoring time t.

When a positive deviation of the respective determined aggregated deviation value 10 from the respective reference aggregated deviation value 12 exceeds the threshold value 18 for a predetermined duration of monitoring time t, a potentially anomalous state of the battery block is detected.

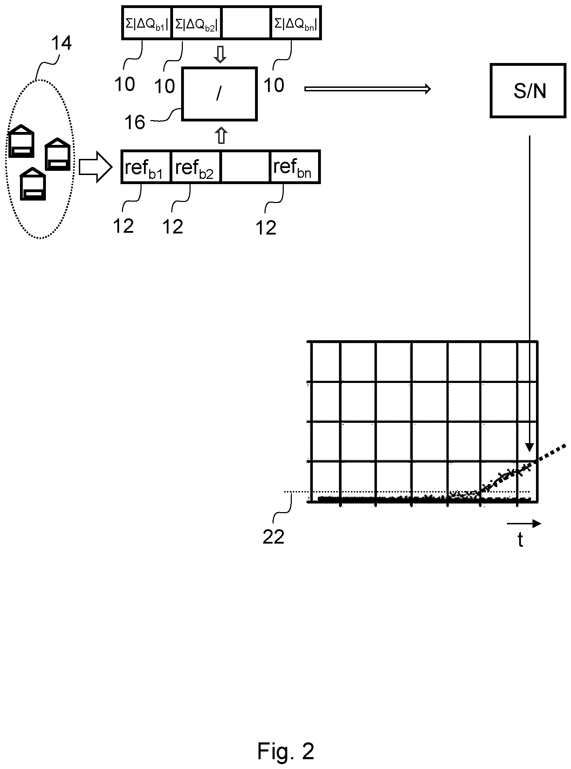

Fig. 2 is a schematic illustration of steps of another method of monitoring the behavior of a plurality of battery blocks that are connected in series in a battery. The first part of the method is similar to the method of Fig. 1. The second part of the method is described in the following.

As indicated by "S/N", a ratio of the square of the aggregated deviation value 10 of the battery block to the sum of the squares of the aggregated deviation values of the other battery blocks of the plurality of battery blocks is calculated, similar to a signal-to-noise ratio. Thus, the (scaled) aggregated deviation value 10 of a battery block is related to the aggregated deviation values 10 of the other battery blocks of the plurality of battery blocks b1, ..., bn.

In the lower right part of Fig. 2, there is shown a diagram of the resulting ratio of each of the battery blocks b1, ..., bn over the monitoring time t.

As shown in the example of Fig. 2, one of the battery blocks exhibits a behavior that exceeds a fourth threshold value 22, which is indicated by a thin dotted line. In particular, the ratio shows a positive deviation with respect to the fourth threshold value 22 for the latest part of the monitoring time t. Furthermore, it is determined that, for the latest part of the monitoring time t that includes the current time t, the positive deviation overall increases over monitoring time t, as indicated by a thick dotted line. Based thereon, a potentially anomalous state of the battery block is detected.

## Claims

1. A method of monitoring the behavior of a plurality of battery blocks (b1, ..., bn) that are connected in series in a battery, for detecting a potentially anomalous state of one of the plurality of battery blocks (b1, ..., bn), the method comprising:
for each point in time of a plurality of points in time (t₀, t ₋₁, t ₋₂, ...), providing a voltage measurement (U_{b1}, ..., U_{bn}) of each of the plurality of battery blocks (b1, ..., bn) measured at the point in time;
for each point in time of the plurality of points in time (t₀, t ₋₁, t ₋₂, ...), and for each battery block of the plurality of battery blocks (b1, ..., bn), calculating a deviation value (ΔU_{b1}, ..., ΔU_{bn}; ΔQ_{b1}, ..., ΔQ_{bn}) of the battery block, wherein the deviation value is a voltage deviation of the voltage measurement of the battery block from an average (M) of the voltage measurements (U_{b1}, ..., U_{bn}) of the plurality of battery blocks (b1, ..., bn), or is a charge deviation of the battery block that corresponds to the voltage deviation;
for each battery block of the plurality of battery blocks (b1, ..., bn) and for a first time frame (T1), aggregating the deviation values (ΔQ_{b1}, ..., ΔQ_{bn}) of the battery block that have been calculated for the points in time belonging to the first time frame (T1), to determine an aggregated deviation value (10); and
for each battery block of the plurality of battery blocks (b1, ..., bn), evaluating the aggregated deviation value (10) to detect a potentially anomalous state of the battery block, said evaluating comprises evaluating the aggregated deviation value (10) with respect to at least one reference aggregated deviation value (12), wherein the at least one reference aggregated deviation value (12) is obtained based on corresponding aggregated deviation values (10) of a corresponding battery block of corresponding batteries (14).

2. The method according to claim 1, wherein said average (M) of the voltage measurements (U_{b1}, ..., U_{bn}) of the plurality of battery blocks (b1, ..., bn) is the median of the voltage measurements of the plurality of battery blocks (b1, ..., bn).

3. The method according to any one of the preceding claims, wherein said aggregating comprises calculating the sum of the absolute values of the deviation values (ΔQ_{b1}, ..., ΔQ_{bn}) of the respective battery block that have been calculated for the points in time belonging to the first time frame (T1).

4. The method according to any one of the preceding claims, wherein said evaluating of the aggregated deviation value (10) with respect to at least one reference aggregated deviation value (12) comprises scaling (16) and/or adjusting the determined aggregated deviation value (10) based on the at least one reference aggregated deviation value (12), or comprises comparing the determined aggregated deviation value (10) to at least one of the at least one reference aggregated deviation value (12).

5. The method according to any one of the preceding claims, wherein the at least one reference aggregated deviation value (12) is a statistical representation of corresponding aggregated deviation values (10) of a corresponding battery block of corresponding batteries (14).

6. The method according to any one of the preceding claims, wherein at least one of the at least one reference aggregated deviation value (12) is an n-th q-quantile of the corresponding aggregated deviation values (10) of a corresponding battery block of corresponding batteries (14), wherein n/q is at least 0.75.

7. The method according to any one of the preceding claims, wherein at least one of the at least one reference aggregated deviation value (12) is an (q-n)-th q-quantile of the corresponding aggregated deviation values (10) of a corresponding battery block of corresponding batteries (14), wherein n/q is at least 0.75.

8. The method according to any one of the preceding claims, wherein the charge deviation of the respective battery block is estimated based on the voltage deviation of the battery block and based on a voltage-charge characteristic.

9. The method according to any one of the preceding claims, wherein the steps of aggregating the deviation values and evaluating the aggregated deviation value (10) to detect a potentially anomalous state of the battery block are repeated for at least one second time frame (T2), wherein said evaluating comprises: when a deviation of the respective determined aggregated deviation value (10) from at least one of the respective at least one reference aggregated deviation value (12) passes a threshold value (18) for a predetermined duration of monitoring time (t), detecting a potentially anomalous state of the battery block.

10. The method according to any one of the preceding claims, wherein said evaluating the aggregated deviation value (10) to detect a potentially anomalous state of the battery block further comprises: evaluating a ratio of the square of the aggregated deviation value of the battery block to the sum of the squares of the aggregated deviation values of the other battery blocks of the plurality of battery blocks.

11. The method according to claim 10, wherein the steps of aggregating the deviation values and evaluating a ratio are repeated for at least one second time frame (T2), wherein said evaluating comprises: when the respective ratio passes a third threshold value (22) for a predetermined duration of monitoring time (t), detecting a potentially anomalous state of the battery block.

12. The method according to claim 10 or 11, wherein the steps of aggregating the deviation values and evaluating a ratio are repeated for at least one second time frame (T2), wherein said evaluating comprises: detecting a positive deviation of the respective ratio with respect to a fourth threshold value (22); and determining whether the positive deviation increases over monitoring time.

13. A battery monitoring system (100), the system comprising means for carrying out the steps of the method of any one of claims 1 to 12.
